(19) Europäisches Patentamt
European Patent Office
Office européen des brevets

(11) EP 2 186 838 B1

(12) **EUROPEAN PATENT SPECIFICATION**

(45) Date of publication and mention of the grant of the patent:
**27.08.2014 Bulletin 2014/35**

(21) Application number: **08790535.2**

(22) Date of filing: **29.08.2008**

(51) Int Cl.:
***C08F 297/02*** $^{(2006.01)}$ ***G03F 7/039*** $^{(2006.01)}$
*C08F 220/18* $^{(2006.01)}$

(86) International application number:
**PCT/JP2008/002381**

(87) International publication number:
**WO 2009/028212 (05.03.2009 Gazette 2009/10)**

(54) **METHOD FOR PRODUCING STAR POLYMER**

VERFAHREN ZUR HERSTELLUNG VON STERNPOLYMEREN

PROCÉDÉ DE PRODUCTION DE POLYMÈRE EN ÉTOILE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **31.08.2007 JP 2007226409**

(43) Date of publication of application:
**19.05.2010 Bulletin 2010/20**

(73) Proprietor: **Nippon Soda Co., Ltd.**
**Tokyo 100-8165 (JP)**

(72) Inventors:
- **SHIRAI, Akihiro**
**Ichihara-shi**
**Chiba 290-0045 (JP)**
- **SHIMOTORI, Takeshi**
**Ichihara-shi**
**Chiba 290-0045 (JP)**
- **MARUMO, Shinji**
**Ichihara-shi**
**Chiba 290-0045 (JP)**
- **NIITANI, Takeshi**
**Ichihara-shi**
**Chiba 290-0045 (JP)**

(74) Representative: **Wibbelmann, Jobst**
**Wuesthoff & Wuesthoff**
**Patent- und Rechtsanwälte**
**Schweigerstrasse 2**
**81541 München (DE)**

(56) References cited:
**EP-A1- 1 752 479** **WO-A1-96/23012**
**WO-A1-2005/116098** **WO-A1-2006/016648**
**JP-A- 2001 106 737** **JP-A- 2006 225 605**

- **L.KILIAN,ET AL. J.POLYMER SCIENCE,PART A 19 August 2003, pages 3083 - 3093, XP002994509**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 186 838 B1

## Description

### Technical Field

The present invention relates a method for producing a star polymer, in particular to a method for producing a star polymer by core-first method.

### Background Art

A star polymer can be produced by various methods, and i) "arm-first" (arm link) method and ii) core-first method (arm growth) are known as a general scheme.

1. Arm-first method

In an arm-first method, a linear polymer having a reaction point at one end (for example a polymerization end for a living polymerization) is prepared. To link the arms to be the core part, there are i) a method using a polyfunctional coupling agent; and ii) a method utilizing a cross-linking reaction of polyfunctional monomer.

1-1. Arm-first method (using a polyfunctional coupling agent)

In a method for producing (meth)acrylic acid ester star polymer, (meth)acrylic acid esters are copolymerized by an anionic living polymerization and a coupling reaction is conducted using a polyfunctional polyhalogen compound to produce a (meth)acrylic acid ester star polymer (for example, see patent document 1).

Further, an example of using a chlorosilane compound as a polyfunctional coupling agent after synthesizing a linear polymer by anionic living polymerization is also known, and a star polymer with an uniform number of branches can be obtained with, for example, a tetrachlorosilane (nonpatent document 1) or 1,2-bis(trichlorosilyl)ethane (nonpatent document 2). However, to synthesize a star polymer with a large number of branches, it is difficult to synthesize a polyfunctional chlorosilane. Further, there are drawbacks in that the density around the core becomes high, and the reaction does not progress quantitatively.

1-2. Arm-first method (cross-linking reaction of polyfunctional monomer)

The following methods can be exemplified: a method for producing a star polymer by performing an anionic living polymerization for a block copolymer of a styrene derivative and (meth)acrylic acid ester, and then adding a di(meth)acrylate compound (for example, patent document 2); a method for producing a star polymer by polymerizing polymethacrylic acid methyl by a living radical polymerization, and then adding a divinyl compound (for example, nonpatent document 3); and a method for producing a star polymer by polymerizing t-butyl acrylate by living radical polymerization, separating it as a macroinitiator, and copolymerizing it with divinylbenzene by living radical polymerization (for example, nonpatent document 4).

When a divinylbenzene is used as a polyfunctional monomer in an arm-first method by anionic living polymerization, it cannot be avoided that double bonds remain. However, there is a method comprising further adding an anionic polymerization initiator to the remaining double bond to use it as the initiating site point of polymerization, and allowing to grow a linear polymer to be the arm (in-out method) (for example, see patent document 3).

However, in both of the method using a polyfunctional coupling agent, and the method of utilizing a cross-linking reaction of a polyfunctional monomer in the arm-first method, all of the linear polymers prepared in the first step are not allowed to react, and some linear polymers inevitably remain unreacted. When linear polymers remain, there are drawbacks in that the desired property of a star polymer cannot be obtained. Alternatively, it would be necessary to perform a purification treatment to remove the remaining linear polymers.

2. Core-first method

In the core-first method, a method comprising using a polyfunctional initiator having plural functional groups each of which can initiate chain polymerization as a core molecule, and allowing to grow a linear polymer to be the arm part, is well known.

In the core-first method, there is a method of using a functional group that can be the initiating site of living radical polymerization as a polyfunctional initiator, and allowing to grow a linear polymer to be the arm part by living radical polymerization (for example, nonpatent document 5).

Further, a method of utilizing a dendrimer having multiple branched chains is also known (for example, see

patent document 4).

However, synthesis of dendrimer, and the polyfunctional initiator that can be the core require a high synthesis technique.

In the core-first method, it is possible on the scheme, to first polymerize a polyfunctional monomer, and then adding a monomer to allow growing the linear polymer to be the arm. However, usually, in any polymerization method (free radical, living anion, living cation, living radical), when polymerizing polyfunctional monomers, the growing reaction and the cross-linking reaction (in molecular chains and between molecular chains) progress at the same time. Therefore a high molecular gel is immediately generated, and as it has a high viscosity, or is deposited in a solvent, it is very difficult to allow growing a liner polymer to be the arm continuously.

As a method for forming a core by a cross-linking reaction of a polyfunctional monomer, it has been reported to use a divinylbenzene as a polyfunctional monomer (for example, nonpatent document 6). This is achieved by selecting carefully the polymerization conditions so that it becomes a microgel having a suitable size in the living anionic polymerization of divinylbenzene to be the core.

However, when divinylbenzene is used, it cannot be used for a material to which transparency is necessary. For example, for a photoresist material of photolithography processing, as the transparency against argon fluoride exima laser (wave length: 193 nm) to the light source is critical, a resin containing aromatic ring cannot be used.

Further, when divinylbenezene is used as a monomer of the core part, as unreacted vinyl groups remain, problems such as low transparency, degradation and deterioration due to radical generation, cross-linking reaction, and coloring, etc. may occur.

[Patent document 1] Japanese Laid-Open Patent Application No. 11-29617
[Patent document 2] Japanese Laid-Open Patent Application No.2006-225605
[Patent document 3] Japanese Patent No. 3188611 [Patent document 4] Japanese Laid-Open Patent Application No.6-219966
[Nonpatent document 1] Macromolecules, 1996, 29, 3390-3396
[Nonpatent document 2] Macromolecules, 1999, 32, 534-536 [Nonpatent document 3] Macromolecules, 2001, 34, 7629-7635
[Nonpatent document 4] Macromolecules, 2005, 38, 2911-2917
[Nonpatent document 5] Macromolecules, 1999, 32, 6526-6535
[Nonpatent document 6] Macromolecules, 1991, 24, 5897-5902

WO 96/23012 A1 discloses a star-branched polymer comprising a core portion and polymeric arms. The core portion is obtained by anionic polymerization of at least one unsaturated acrylate or methacrylate ester of a polyol, and the polymeric arms are obtained by anionic polymerization of at least one acrylic or methacrylic monomer. An organic alkali metal compound may be used during the production process.

EP 1 752 479 A1 discloses an acrylic based star polymer prepared by an arm first method which has as a core portion a polymer chain having a repeated unit derived from a polyacrylate, wherein an inorganic salt of an alkali metal and an organic alkali metal compound are used during the production of said polymer.

## Disclosure of the Invention

Object to be solved by the Invention

The present invention is to provide a star polymer that can be used as a material for a photoresist material of photolithography processing, with no linear polymer remained.

Means to solve the object

The present inventors have made a keen study to solve the above objects, and as a result they have found out that by adjusting the used amount of a halide of an alkali metal and organic alkali metal salt, a core part having (meth)acrylic acid ester derivative as a raw material can be produced without generating a high molecular gel, and thus, a star polymer that can be used as a photoresist material of photolithography processing with no linear polymer remained, can be produced. The present invention has been thus completed.

Specifically, the present invention relates to:

(1) a method for producing a star polymer, comprising
forming a core part by producing a polymer by polymerizing one or more polyfunctional (meth)acrylic acid ester derivative represented by formula (IV)

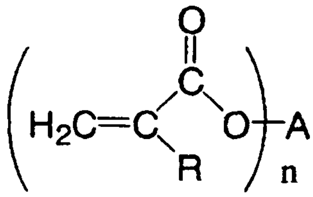

(IV)

(wherein R represents a hydrogen atom or C1-C6 alkyl group, n represents 2 or 3, and A represents an organic group linking at a carbon atom) by anionic polymerization in an organic solvent, in the presence of 0.1 to 0.99 mol of organic alkali metal compound with respect to 1 mol of the compound of the formula (IV), and in the presence of 0.1 to 20 mol of inorganic salt of alkali metal or alkali earth metal with respect to 1 mol of the organic alkali metal compound,

and then, forming an arm part by polymerizing one or more monofunctional (meth)acrylic acid ester derivative represented by formula (I)

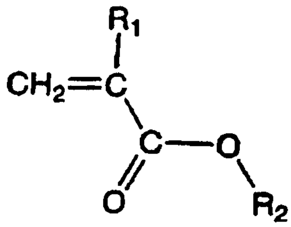

• • • (I)

(wherein $R_1$ represents a hydrogen atom or C1-C5 alkyl group, and $R_2$ represents an organic group) by anionic polymerization from the anionic active site of the core part;

(2)the method for producing a star polymer according to (1), wherein the halide of alkali metal is lithium chloride, and the organic alkali metal compound is sec-butyl lithium;

(3) the method for producing a star polymer according to (1) or (2), wherein the polyfunctional (meth)acrylic acid ester derivative represented by formula (IV) is a polyfunctional (meth)acrylic acid ester derivative having at least 2 partial structure represented by formula (II)

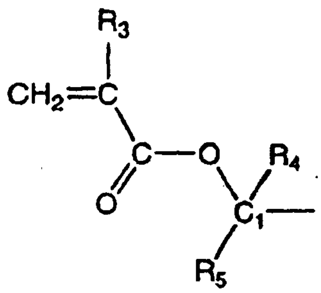

• • • (II)

(wherein $R_3$ represents a hydrogen atom or C1-C6 alkyl group; $R_4$ and $R_5$ each independently represent a hydrogen atom, or an organic group linking at a carbon atom);

(4) a producing method wherein the polyfunctional (meth)acrylic acid ester derivative represented by formula (IV) is a polyfunctional (meth)acrylic acid ester derivative represented by formula (III)

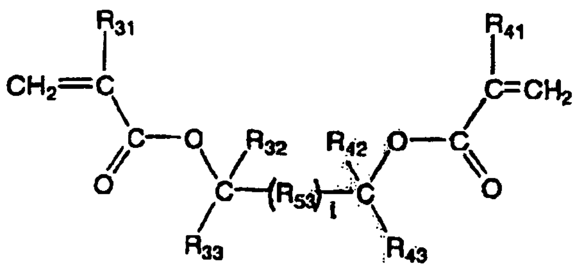

• • • (III)

(wherein, $R_{31}$ and $R_{41}$ each independently represent a hydrogen atom or C1-C6 alkyl group, and $R_{32}$, $R_{33}$, $R_{42}$, and $R_{43}$ each independently represent an organic group linking at a carbon atom, t represents 0 or 1, and $R_{53}$ represents a divalent linking group, and particularly preferably 2,5-dimethyl-2,5-hexanediol di(meth)acrylate.

Further, the present invention relates to a star polymer produced by the method according to any one of (1) to (4).

**Best Mode of Carrying out the Invention**

1) Method for producing a star polymer

The method for producing a star polymer of the present invention consists of the following steps.

First step: (Production of the core part)

A step of producing a polymer having plural anion ends, by polymerizing a polyfunctional (meth)acrylic acid ester derivative represented by formula (IV)

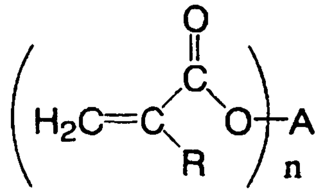

(IV)

by anionic polymerization in an organic solvent in the presence of inorganic salts of alkali metal or alkali earth metal and in the presence of organic alkali metal compound.

Second step: (elongation of the arm part from the core part)

A step of polymerizing a monofunctional (meth)acrylic acid ester derivative represented by formula (I)

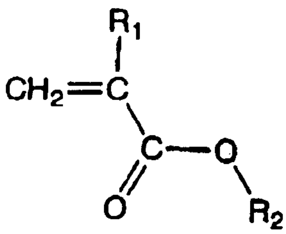

· · · (I)

by anionic polymerization using the anionic end of the polymer having anionic ends obtained in the first step as a starting point.

1-1) First step (production of the core part)

For producing the core part, a polyfunctional (meth)acrylic acid ester derivative represented by formula (IV) is used as a monomer, which is subjected to anionic polymerization in an organic solvent, in the presence of 0.1 to 0.99 mol, preferably 0.25 to 0.75 mol, of organic alkali metal compound with respect to 1 mol of the compound, and in the presence of 0.1 to 20 mol, preferably 0.5 to 3 mol of inorganic salts of alkali metal or alkali earth metal with respect to 1 mol of the organic alkali metal compound.

The used amount of the above organic alkali metal compound or inorganic salts of alkali metal or alkali earth metal is the effective amount excluding the deactivating moiety.

Inorganic salts of alkali metal or alkali earth metal include halides (chloride, bromide, iodide, etc.) of sodium, potassium, lithium, cesium, barium, magnesium, etc. and mineral acid salts (sulfate, nitrate, borate, etc.). Preferred is a lithium chloride.

Examples of organic alkali metal include alkylated, allylated and arylated compounds of lithium, sodium, potassium, cesium, etc. Specific examples thereof include ethyllithium, n-butyllithium, sec-butyllithium, tert-butyllithium, ethylsodium, lithiumbiphenyl, lithiumnaphthalene, lithiumtriphenyl, sodium naphthalene, α-methylstyrene sodium dianion, 1,1-diphenylhexyllithium and 1,1-diphenyl-3-methylpentyllithium. Preferred is sec-butyllithium.

The production of the core part is usually performed under inactive gas atmosphere such as nitrogen and argon, in an organic solvent, at a temperature of -100 to 50°C, preferably -78 to 0° C, and more preferably -60 to -30° C.

Examples of organic solvent include organic solvents which are usually used in the anionic polymerization, such as aliphatic hydrocarbons such as n-hexane and n-heptane; alicyclic hydrocarbons such as cyclohexane and cyclopentane; aromatic hydrocarbons such as benzene and toluene; ethers such as diethylether, tetrahydrofuran (THF) and dioxane; anisole, and hexamethylphosphoramide. These organic solvents may be used alone or as a mixed solvent comprising at least two kinds thereof. Among these mixed solvents, a mixed solvent of tetrahydrofuran and toluene, a mixed solvent of tetrahydrofuran and hexane, and a mixed solvent of tetrahydrofuran and methylcyclohexane are preferably exemplified in view of polarity and solubility.

1-2) Second step (elongation of the arm part from the core part)

After the production of the core part, the arm part is elongated by polymerizing a monofunctional (meth)acrylic acid ester derivative represented by formula (I) by anionic polymerization method in an organic solvent, from an anionic active site of the core part. Here, a solution containing the monofunctional (meth)acrylic acid ester derivative represented by formula (I) may be added to the solvent containing the core part, or on the contrary, the solution containing the core part can be added to the organic solvent containing the monofunctional (meth)acrylic acid ester derivative represented by formula (I).

The elongation of the arm part is usually performed under inactive gas atmosphere such as nitrogen and argon, in an organic solvent, at a temperature of -100 to 50°C, preferably -78 to 0° C, and more preferably -60 to -30° C.

Examples of organic solvent to be used for the elongation of the arm part include the same as for the above first step. It can be sequentially performed in the solvent used to form the core part, or it can be performed by adding a solvent to change the composition or by replacing the solvent with another solvent.

Examples of the polymerization form of the polymer of the arm part include homopolymer, random polymer, partial block copolymer and complete block copolymer. These can be synthesized by selecting a method for adding acrylic acid esters to be used, respectively.

2) Structure of the star polymer

The star polymer of the present invention is constituted by the following core part and arm part.

The number average molecular weight of the whole star polymer is not particularly limited, and can be adjusted appropriately according to the purpose. However, as measured by gel permeation chromatography using polystyrene as a standard, it is preferably 5000 to 100000, and more preferably 10000 to 50000. The ratio (Mw/Mn) of the weight average molecular weight (Mw) and number average molecular weight (Mn) is preferably between 1.1 and 2.0.

2-1) Core part

The core part is a homopolymer or copolymer having one or more polyfunctional (meth)acrylic acid ester derivative represented by formula (IV)

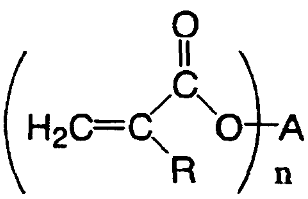

(IV)

(wherein R represents a hydrogen atom or C1-6 alkyl group, n represents 2 or 3, and A represents an organic group linking at a carbon atom) as a monomer. The molecular weight of the core part is not limited as long as it is a size that does not gelatinize or deposit in a polymerization solvent. Usually, the number average molecular weight measured by gel permeation chromatography using polystyrene as standard, is 1000 to 50000, and preferably 3000 to 30000.

Among the monomers represented by the above formula (IV), a polyfunctional (meth)acrylic acid ester derivative having at least 2 partial structures represented by the following formula (II) is preferred.

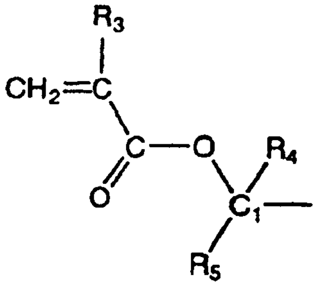

· · · (II)

In formula (II), $R_3$ represents a hydrogen atom or C1-C6 alkyl group; $R_4$ and $R_5$ each independently represent a hydrogen atom, or an organic group linking at a carbon atom. Here, "organic group" is a collective term of a functional group having at least one carbon atom, and "organic group linking by a carbon bond" means that the element at the $\alpha$ site of $C_1$ carbon is a carbon atom in the organic group. Examples of organic group specifically include an alkyl group such as methyl group, ethyl group, n-propyl group, isopropyl group, n-butyl group and t-butyl group, a cycloalkyl group such as cyclopropyl group and cyclohexyl group, an aryl group such as phenyl group and 1-naphtyl group, an aralkyl group such as benzyl group and phenetyl group, an alkenyl group such as vinyl group and allyl group, an alkynyl group such as ethynyl group and propargyl group, a halogenated alkyl group such as chloromethyl group, 2-chloroethyl group and 1-chloroethyl group, and a heterocyclic group such as 2-pyridyl group and 2-pyridyl methyl group.

$C_1$ carbon has another bonds besides bonds to oxygen atom, $R_4$ and $R_5$, and the partner to be bound is a carbon atom. Specifically, it means that it is not bound to an atom other than carbon atom such oxygen atom and sulfur atom. Other parts having a carbon atom at the end are not particularly limited as long as it is a structure that can have at least one of the partial structures represented by formula (II). Specifically, structures showed in the following can be exemplified. However, the partial structures represented by formula (II) are omitted. Meanwhile, the 2 or more partial structures represented by formula (II) may be the same or different.

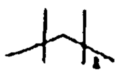

a = 1 ~ 2 0

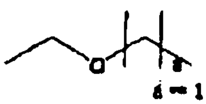

a = 1 ~ 2 0

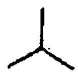

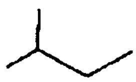

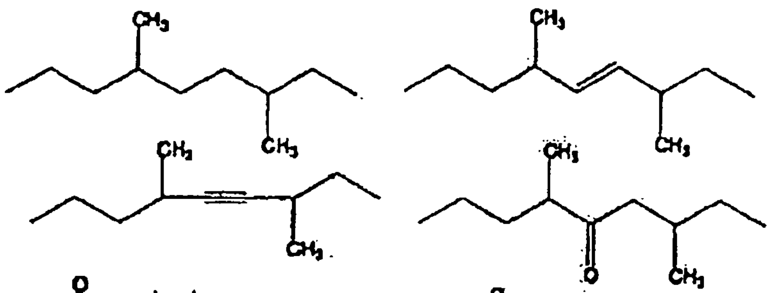

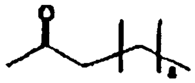

a = 0 ~ 2 0

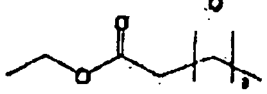

a = 0 ~ 2 0

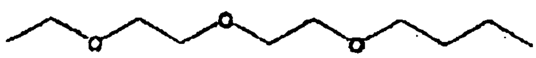

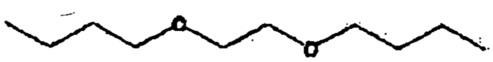

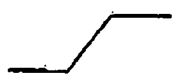

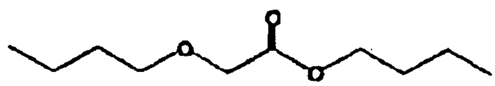

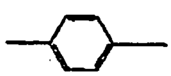

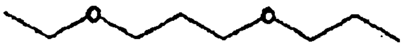 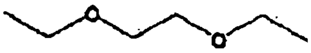

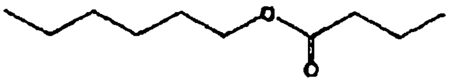

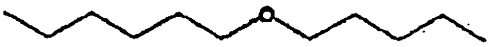

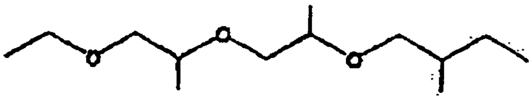

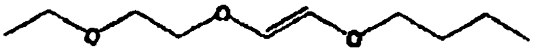

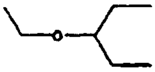 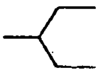 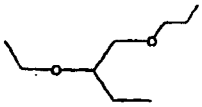

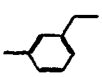 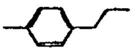 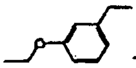 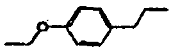

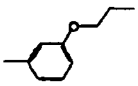 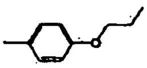 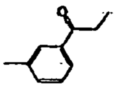 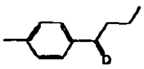

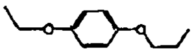 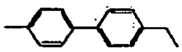

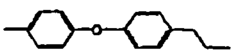 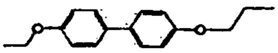

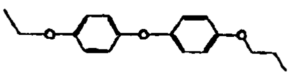

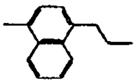 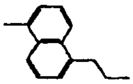 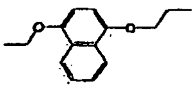

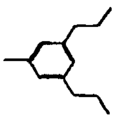 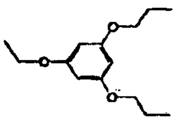

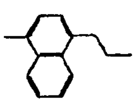 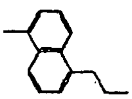 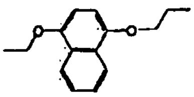

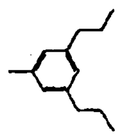 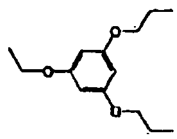

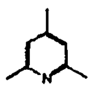 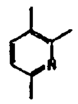 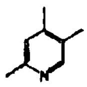 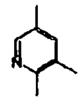 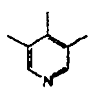

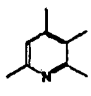 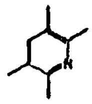 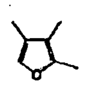 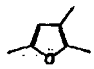 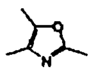

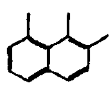 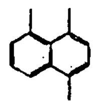 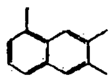 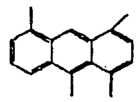

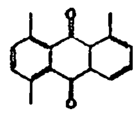 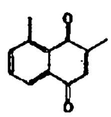 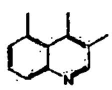 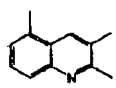 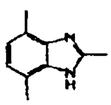

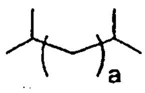 a=1-20 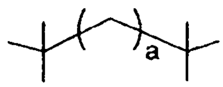 a=1-20

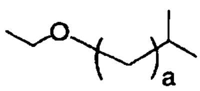 a=1-20 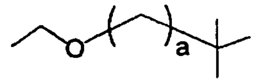 a=1-20

As for a polyfunctional (meth)acrylic acid ester derivative having 2 or more partial structures represented by formula (II), particularly, a polyfunctional (meth)acrylic acid ester derivative represented by formula (III) can be preferably exemplified.

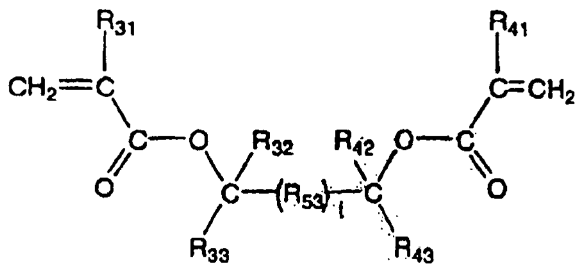 · · · (III)

In formula (III), $R_{31}$ and $R_{41}$ each independently represent a hydrogen atom or C1-C6 alkyl group, and $R_{32}$, $R_{33}$, $R_{42}$ and $R_{43}$ each independently represent an organic group linking at a carbon atom, which specific examples include the same examples listed for $R_4$ and $R_5$. "t" represents 0 or 1, $R_{53}$ represents a divalent linking group, and divalent linking groups in the linking groups shown specifically in the above can be similarly exemplified.

Examples of a polyacrylate having at least 2 partial structures represented by formula (II) include the following compounds, other than 2,5-dimethyl-2,5-hexanediol dimethacrylate used in the Examples.

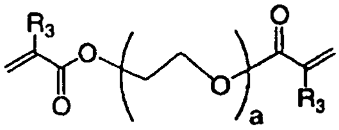

a=1-20

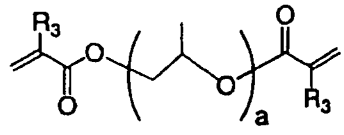

a=1-20

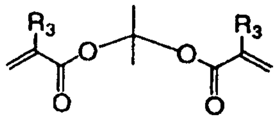

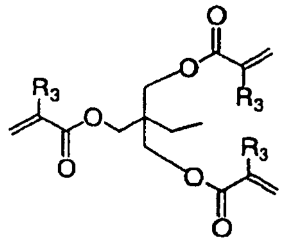

The ratio of repeating units of the polyfunctional (meth)acrylic acid ester derivative having at least 2 partial structures represented by formula (II) is preferably 1 to 50 mol% with respect to all repeating units of the star polymer, more preferably 3 to 30 mol%, and particularly preferably 5 to 20 mol%.

2-2) Arm part

The arm part is a homopolymer or copolymer having one or more monofunctional (meth)acrylic acid ester derivative represented by formula (I)

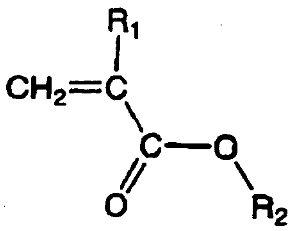 • • • (I)

(wherein $R_1$ represents a hydrogen atom or C1-C5 alkyl group, and $R_2$ represents an organic group) as a monomer. The copolymer may be a random or block copolymer.

The molecular weight of the arm part is not particularly limited, and can be adjusted appropriately according to the purpose.

It is preferred that the repeating unit of the monofunctional (meth)acrylic acid ester derivative represented by formula (I) is contained by 70 mol% or more with respect to all repeating units in the arm part, and more preferably 80 to 100 mol%.

As C1-C5 alkyl group in $R_1$, a methyl group is preferred. The organic group in $R_2$ is a collective term of a functional group containing at least one carbon atom, and a group with C5 or more is preferred, more preferably C6 - C20. Preferred examples include an organic group having an alicyclic hydrocarbon backbone, and an organic group having a lactone ring, and it is preferred that both of them are contained. Specifically, it is preferred that the polymer chain constituting the arm part contains a repeating unit of (meth)acryl ester derivative represented by formula (I) wherein $R_2$ is an organic group having an alicyclic hydrocarbon backbone, and a repeating unit of (meth)acryl ester derivative represented by formula (I) wherein $R_2$ is an organic group having a lactone ring. As an organic group having an alicyclic hydrocarbon backbone is preferably an organic group having a tertiary carbon at the $\alpha$ site of ester oxygen.

Here, it is preferred that the repeating unit of (meth)acryl ester derivative represented by formula (I) wherein $R_2$ is an organic group having an alicyclic hydrocarbon backbone is contained by 20 to 80 mol % with respect to all repeating units of the arm part, more preferably 30 to 70%, and most preferably 40 to 60 mol%. Further, it is preferred that the repeating unit induced from ($\alpha$-lower alkyl) acrylic acid ester represented by formula (I) wherein $R_2$ is an organic group having a lactone ring is contained by 1 to 60 mol% with respect to all repeating units, more preferably 10 to 60 mol%, and most preferably 20 to 50%.

In the following, organic groups of $R_2$ are exemplified.

Examples of "alkyl group" or "cycloalkyl group" include methyl, ethyl, n-propyl, i-propyl, s-butyl, t-butyl, n-pentyl, n-hexyl, cyclopentyl, cyclohexyl, 1-methylcyclopentyl, 1-ethylcyclopentyl, 1-methylcyclohexyl, and 1-ethylcyclohexyl.

Examples of "glycol group" include methoxypolyethylene glycol (number of units of ethylene glycol being 2 to 100), ethoxypolyethylene glycol, phenoxypolyethylene glycol, methoxypolypropylene glycol (number of units of propylene glycol being 2 to 100), ethoxypolypropylene glycol, phenoxypolypropylene glycol, polyethylene glycol, polypropylene glycol, polyethylene glycol-polypropylene glycol, octoxypolyethylene glycol-polypropylene glycol, lauroxypolyethylene glycol, stearoxy polyethylene glycol, "BLEMMER PME series; NOF Corporation", acetyloxy polyethylene glycol, benzoyloxy polyethylene glycol, trimethylsilyloxypolyethylene glycol, t-butyl dimethylsilyloxypolyethylene glycol, and methoxypolyethylene glycol. These may be used by mixing 2 or more kinds.

Specific examples of "organic group having an alicyclic hydrocarbon backbone" include the organic groups represented by the following formulae (V)-a and (V)-b.

$$-A-B \quad \cdots (V)\text{-}a$$

$$-B \quad \cdots (V)\text{-}b$$

In the formulae, A represents a divalent group including an ether group, ester group, carbonyl group, alkylene group, or a combination of these, and divalent groups represented by the following formulae can be specifically exemplified.

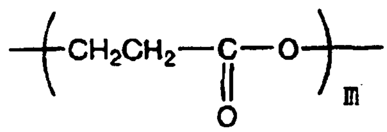
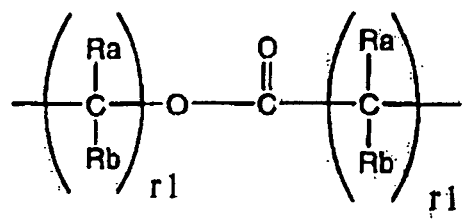

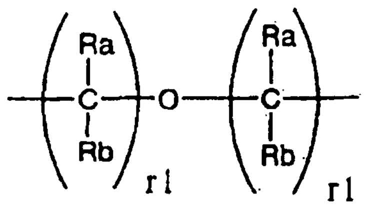
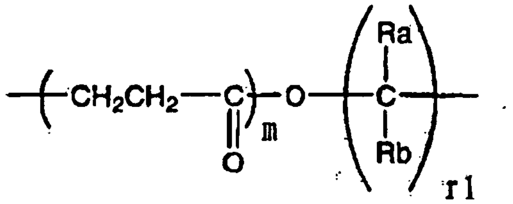

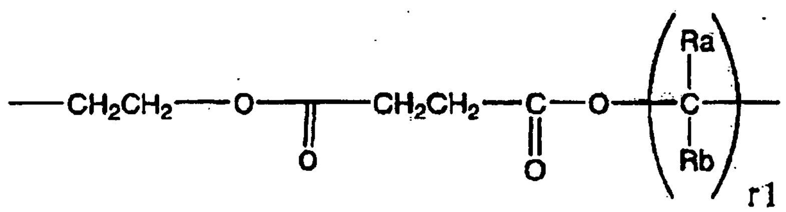

In the above formulae, $R_a$ and $R_b$ each independently represent a hydrogen atom, an alkyl group optionally having a substituent, halogen atom, hydroxyl group, and alkoxy group, and specifically a C1-C6 alkyl group such as a methyl group, ethyl group, n-propyl group, isopropyl group, n-butyl group, etc. can be exemplified. Examples of a substituent of a substituted alkyl group include a hydroxyl group, carboxyl group, halogen atom and alkoxy group. Examples of alkoxy group include those with C1 to C4 such as a methoxy group, ethoxy group, propoxy group, and butoxy group. Examples of a halogen atom include a chlorine atom, bromine atom, fluorine atom, and iodine atom. "r1" represents any integer of 1 to 10, and m represents any integer of 1 to 3.

In the formulae, B represents any of the following formulae (V-1) to (V-6).

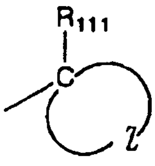
(V-1)

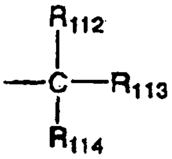
(V-2)

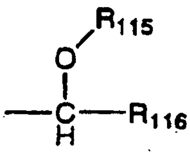
(V-3)

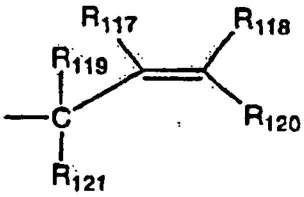
(V-4)

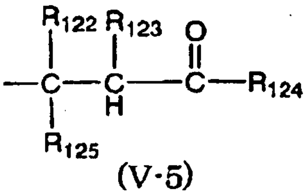
(V-5)

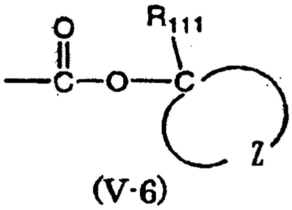
(V-6)

In the above formulae (V-1) and (V-6), $R_{111}$ represents a hydroxyl group, carboxyl group, C1-C5 alkyl group, and Z represents an atom group necessary to form an alicyclic hydrocarbon group together with a carbon atom. When $R_{111}$ is a C1-C5 alkyl group, the hydrocarbon may have a linear chain or a branched chain. The same applies when it is referred to an alkyl group in the following.

In the above formulae (V-2) and (V-3), $R_{112}$ to $R_{116}$ represent a hydroxyl group, carboxyl group, C1-C4 alkyl group, or an alicyclic hydrocarbon group. However, at least one of $R_{112}$ to $R_{114}$, or either $R_{115}$ or $R_{116}$ represents an alicyclic hydrocarbon group.

In the above formula (V-4), $R_{117}$ to $R_{121}$ each independently represent a hydroxyl group, carboxyl group, hydrogen atom, C1-C4 alkyl group, or an alicyclic hydrocarbon group. However, at least one of $R_{117}$ to $R_{121}$ represents an alicyclic hydrocarbon group, and either $R_{119}$ or $R_{121}$ represents a C1-C4 alkyl group, or an alicyclic hydrocarbon group.

In the above formula (V-5), $R_{122}$ to $R_{125}$ each independently represent a hydroxyl group, carboxyl group, hydrogen atom, C1-C4 alkyl group, or an alicyclic hydrocarbon group. However, at least one of $R_{122}$ to $R_{125}$ represents an alicyclic hydrocarbon group.

Specific examples of "alicyclic hydrocarbon group" include the backbones shown in the following formulae.

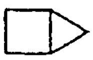
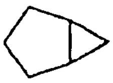
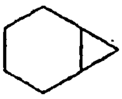
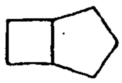
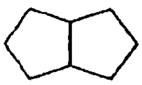
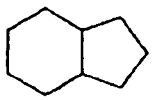
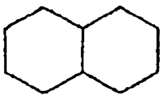
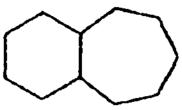
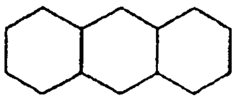
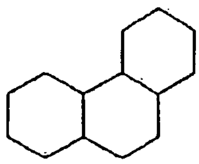
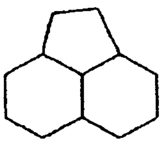
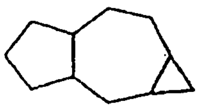
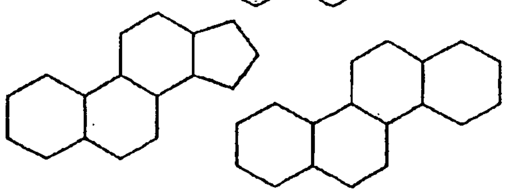
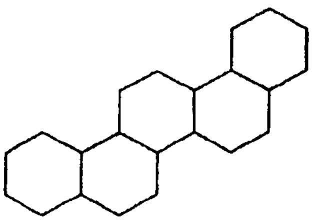
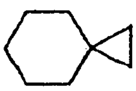
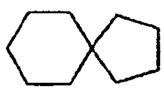
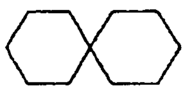

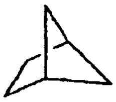 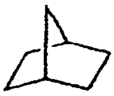 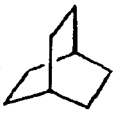 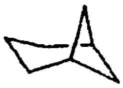 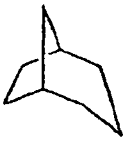 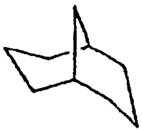

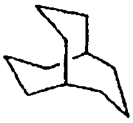 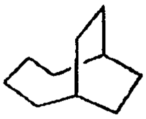 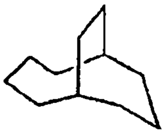 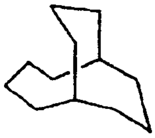 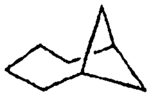

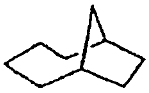 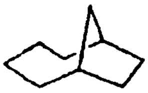 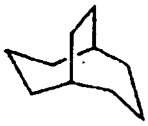 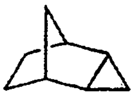 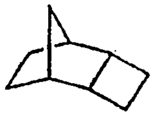

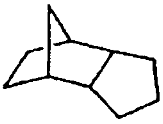 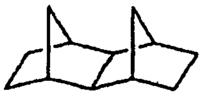 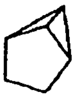 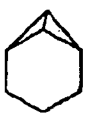 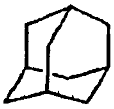

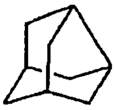 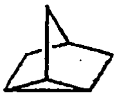 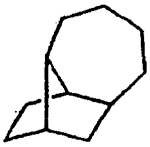 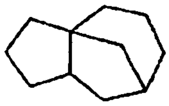 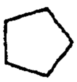 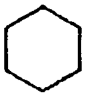

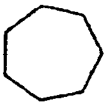 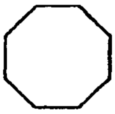 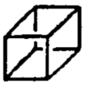 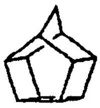

Among these, an adamantyl group is preferred, and an adamantyl group represented by the following formulae (VI-1) to (VI-3) can be preferably exemplified.

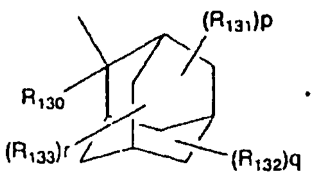 · · · (VI-1)

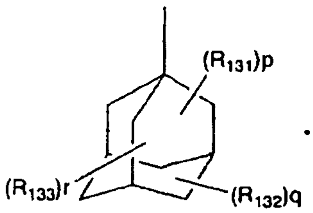 · · · (VI-2)

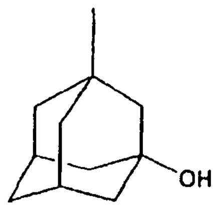 · · · (VI-3)

In the above formulae (VI-1) and (VI-2), $R_{130}$ represents an alkyl group optionally having a substituent, $R_{131}$ to $R_{132}$ each independently represent a hydroxyl group, halogen atom, carboxyl group, alkyl group, cycloalkyl group, alkenyl group, alkoxy group, alkoxycarbonyl group, or acyl group. p, q and r each independently represent 0 or any integer of 1 to 3, and at least one of these is 1 or more. When p, q or r is 2 or more, each $R_{131}$, each $R_{132}$, and each $R_{133}$ may be the same or different.

Specific examples of "(meth)acrylic acid ester derivative represented by formula (I) comprising an organic group having an alicyclic hydrocarbon group" include the compounds shown by the following formulae. $R_9$ and $R_{10}$ each independently represent a linear or branched lower alkyl group.

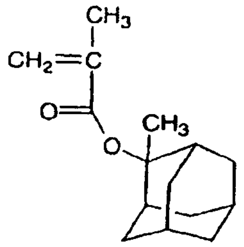
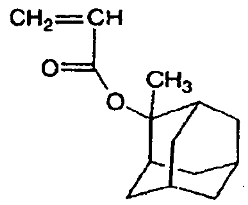
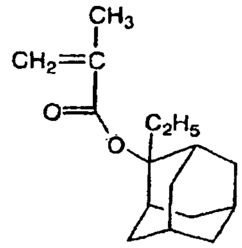

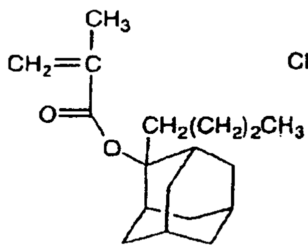
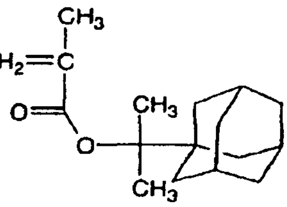
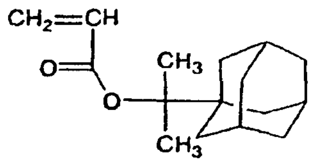

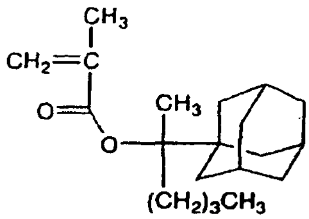
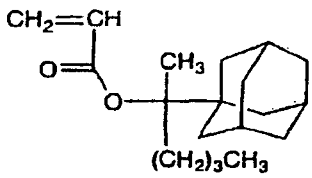
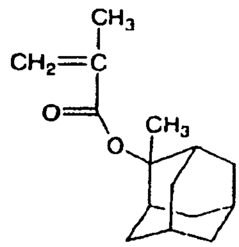

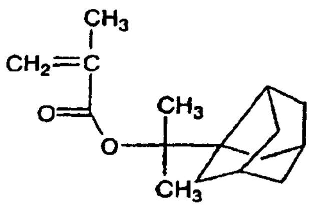
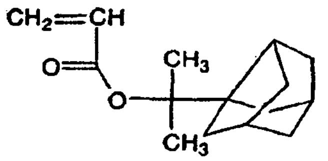
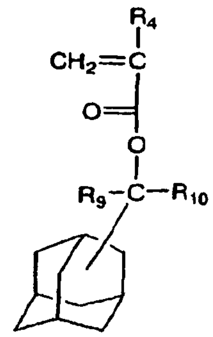

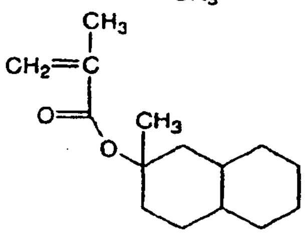
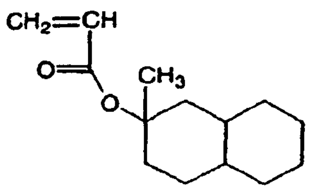

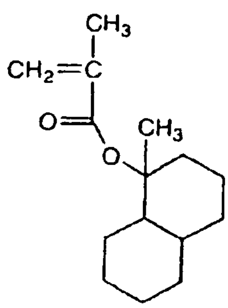
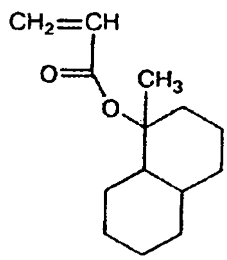
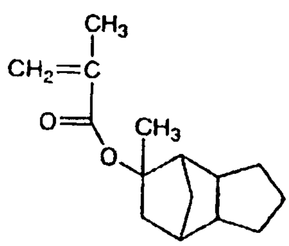

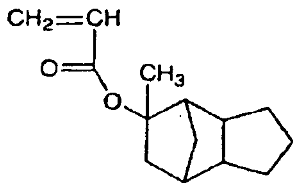
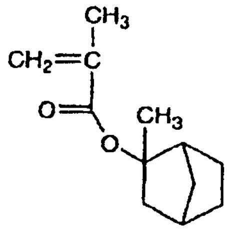
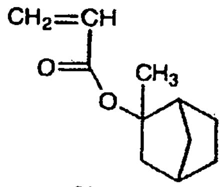

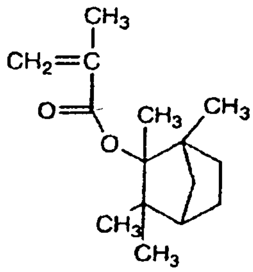
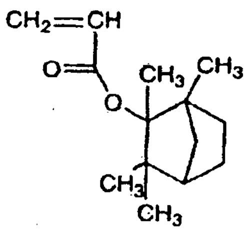
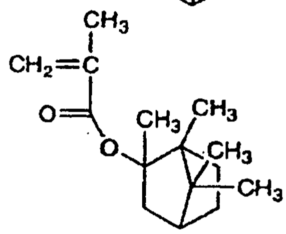

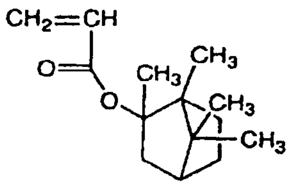
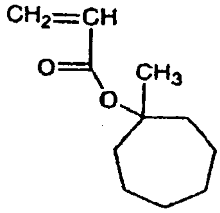
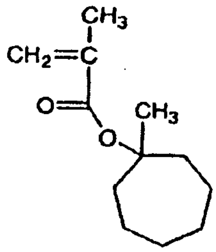

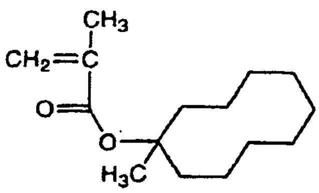
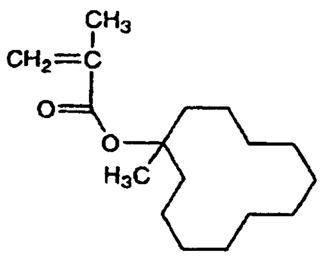

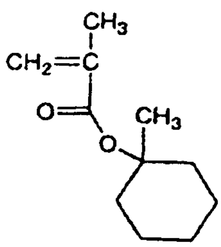
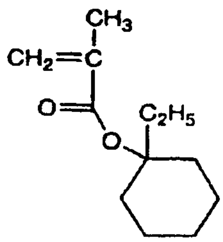

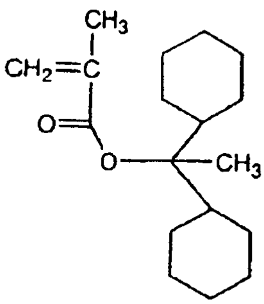
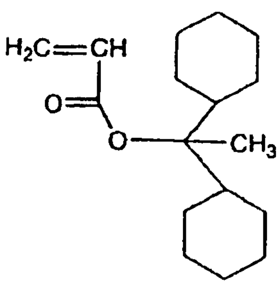
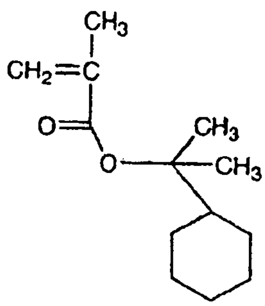

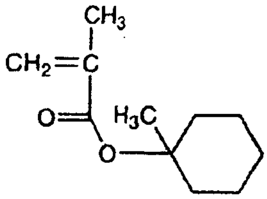

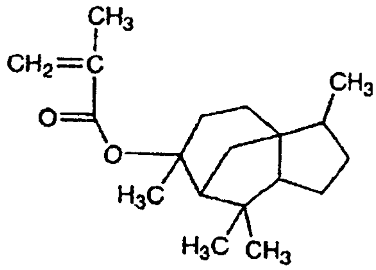

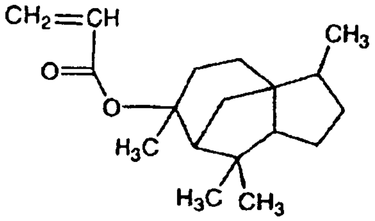

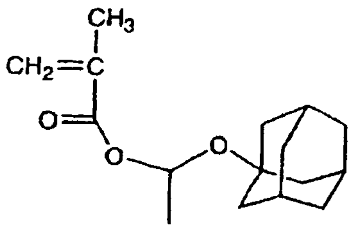

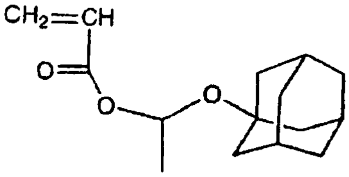

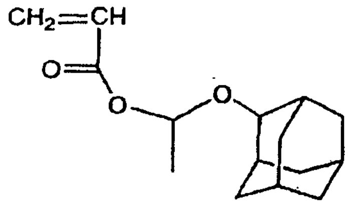

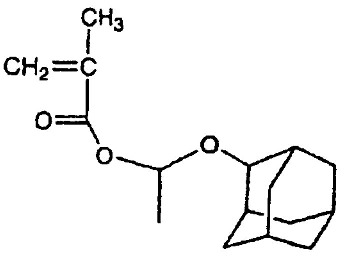

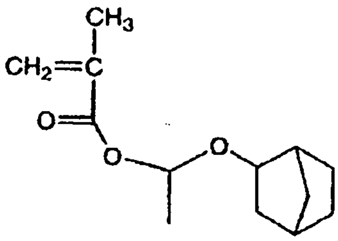

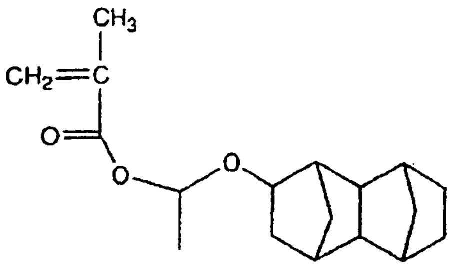

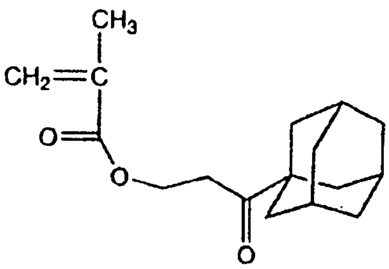

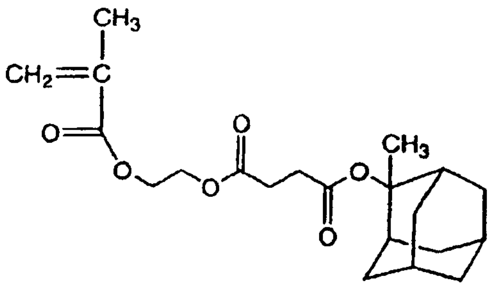

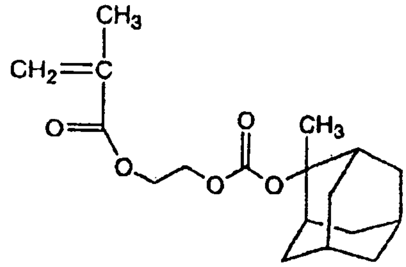

Examples of "(meth)acrylic acid ester derivative represented by formula (I) comprising an organic group having a lactone ring" specifically include butyrolactone acrylate, butyrolactone methacrylate, mevalonic lactone methacrylate,

and pantolactone methacrylate. Further, organic groups represented by the following formulae (VII)-a and (VII)-b can be preferably exemplified.

-A-C ···(VII)-a

-C ···(VII)-b

In the formulae, A has the same meaning as the above divalent groups, and C represents any of the following formulae (VIII-1) to (VIII-5).

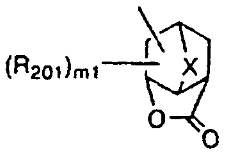

(VIII-1)

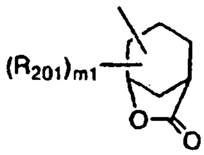

(VIII-2)

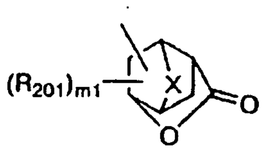

(VIII-3)

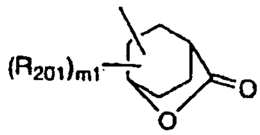

(VIII-4)

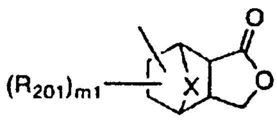

(VIII-5)

In the formulae (VIII-1) to (VIII-5), X represents an oxygen atom, sulfur atom or an alkylene group optionally having a substituent, $R_{201}$ represents an alkyl group, cycloalkyl group, alkenyl group, hydroxyl group or carboxyl group, m1 represents 0 or any integer of 1 to 5, and it is preferred that m1 is 1 or more. When m1 is 2 or more, each $R_{201}$ may be the same or different, or may form a ring by linking to each other.

Examples of "(meth)acrylic acid ester derivative represented by formula (I) comprising an organic group having a lactone group" specifically include the compounds shown by the following formulae.

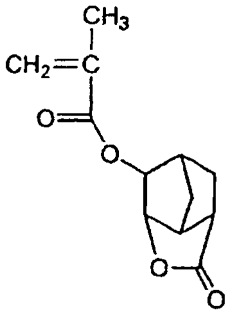
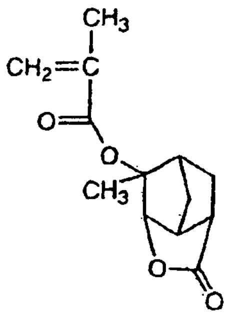
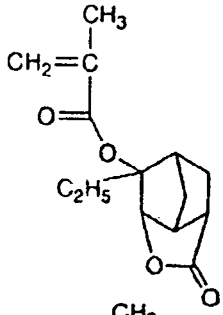
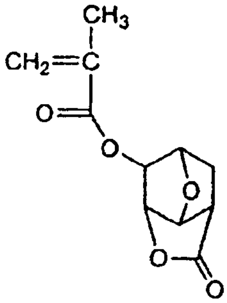
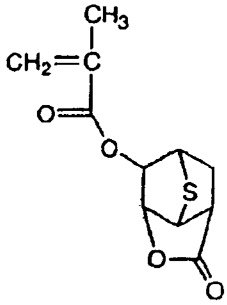
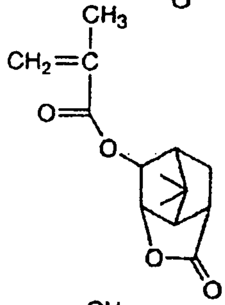
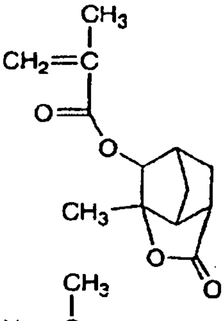
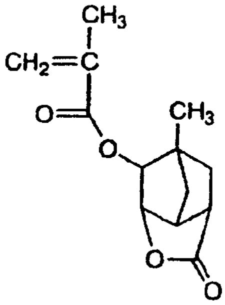
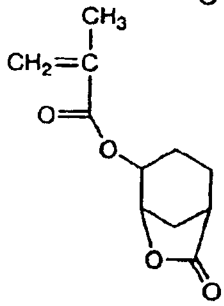
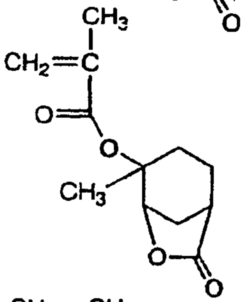
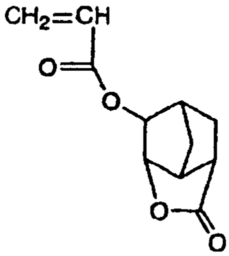
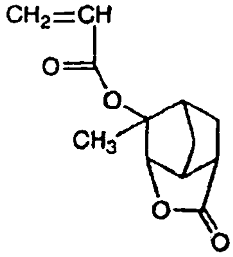
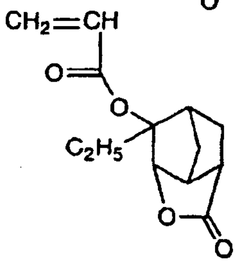
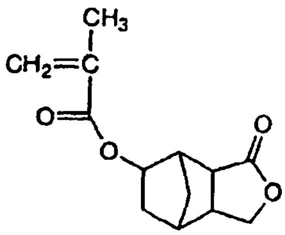
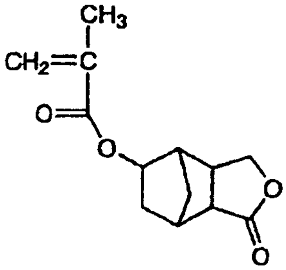

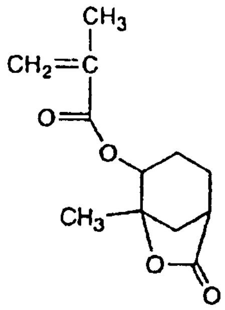
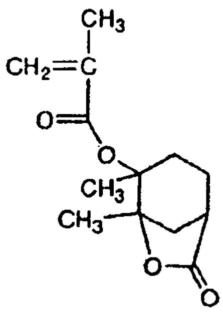
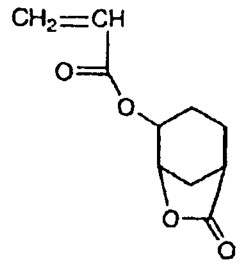
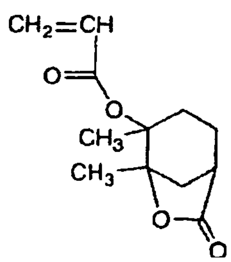
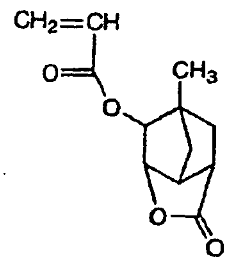
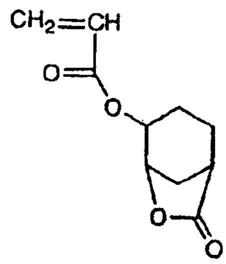
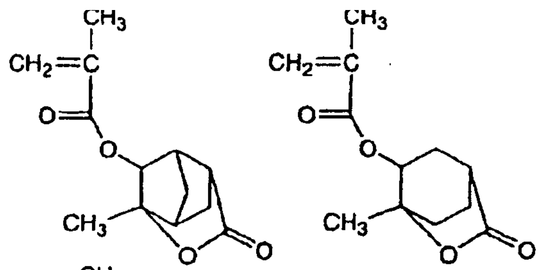
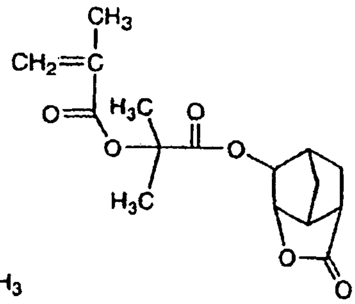
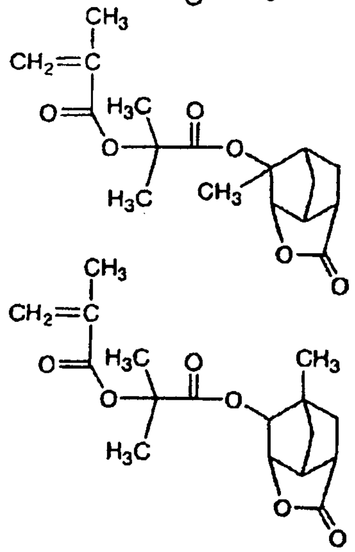
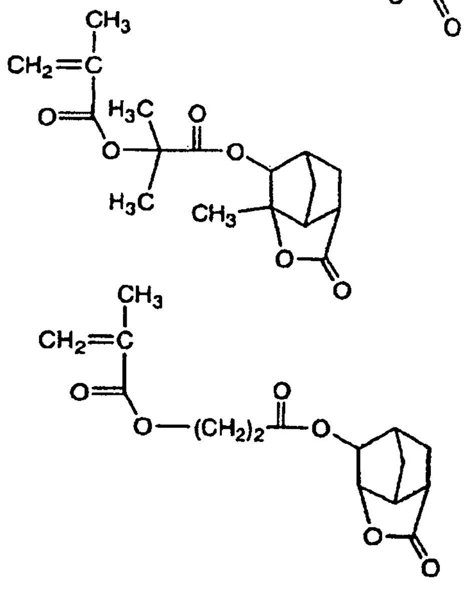

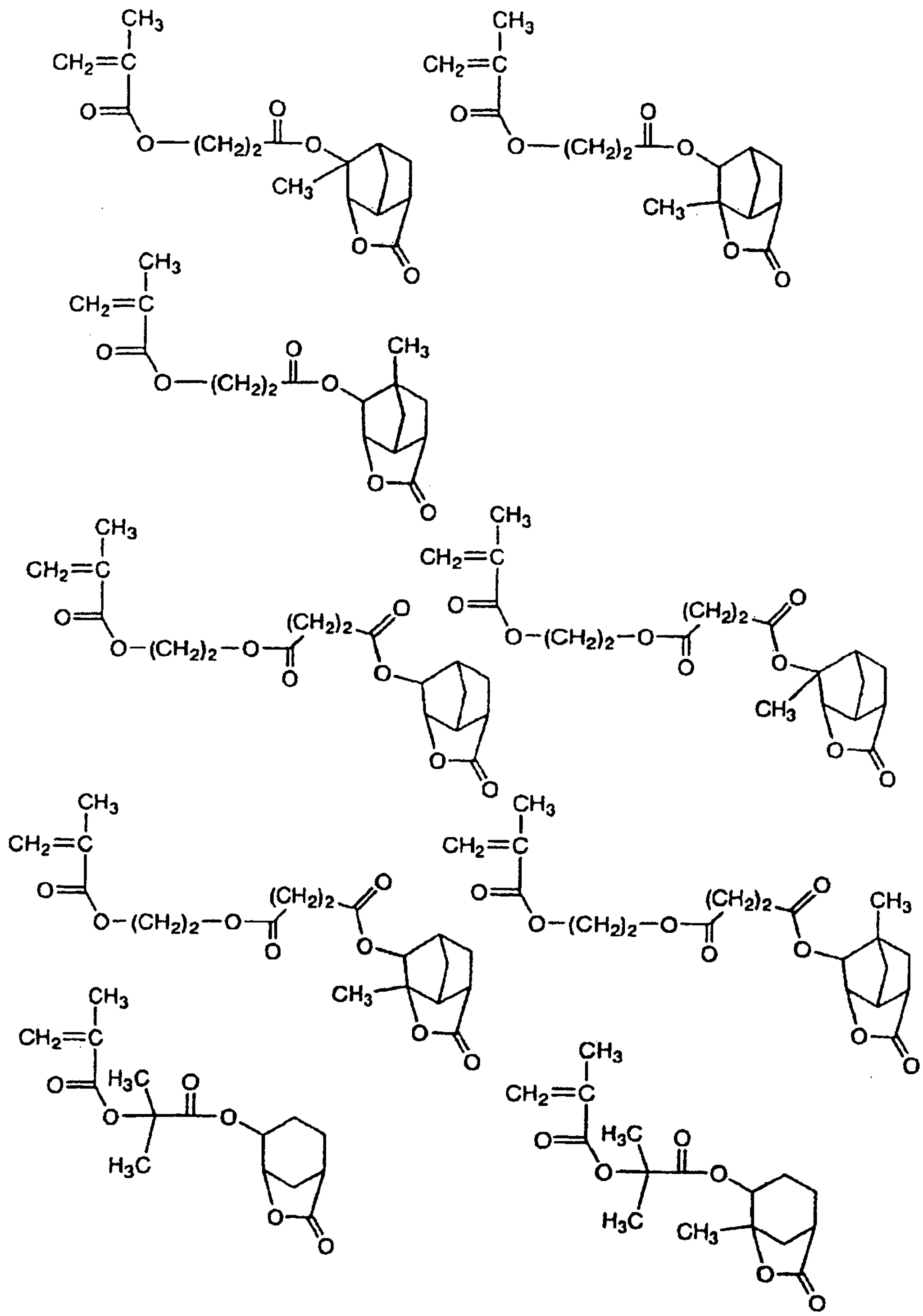

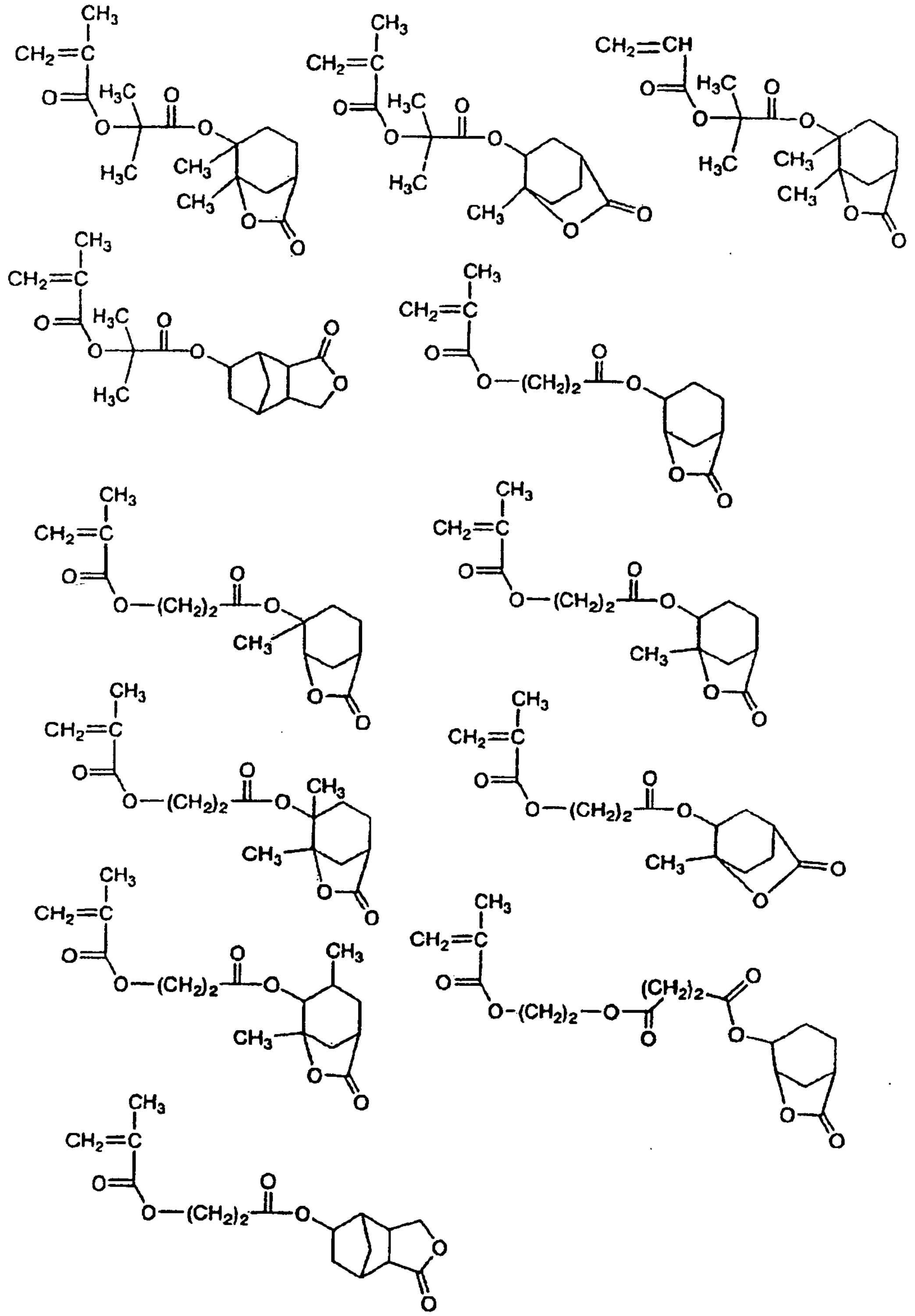

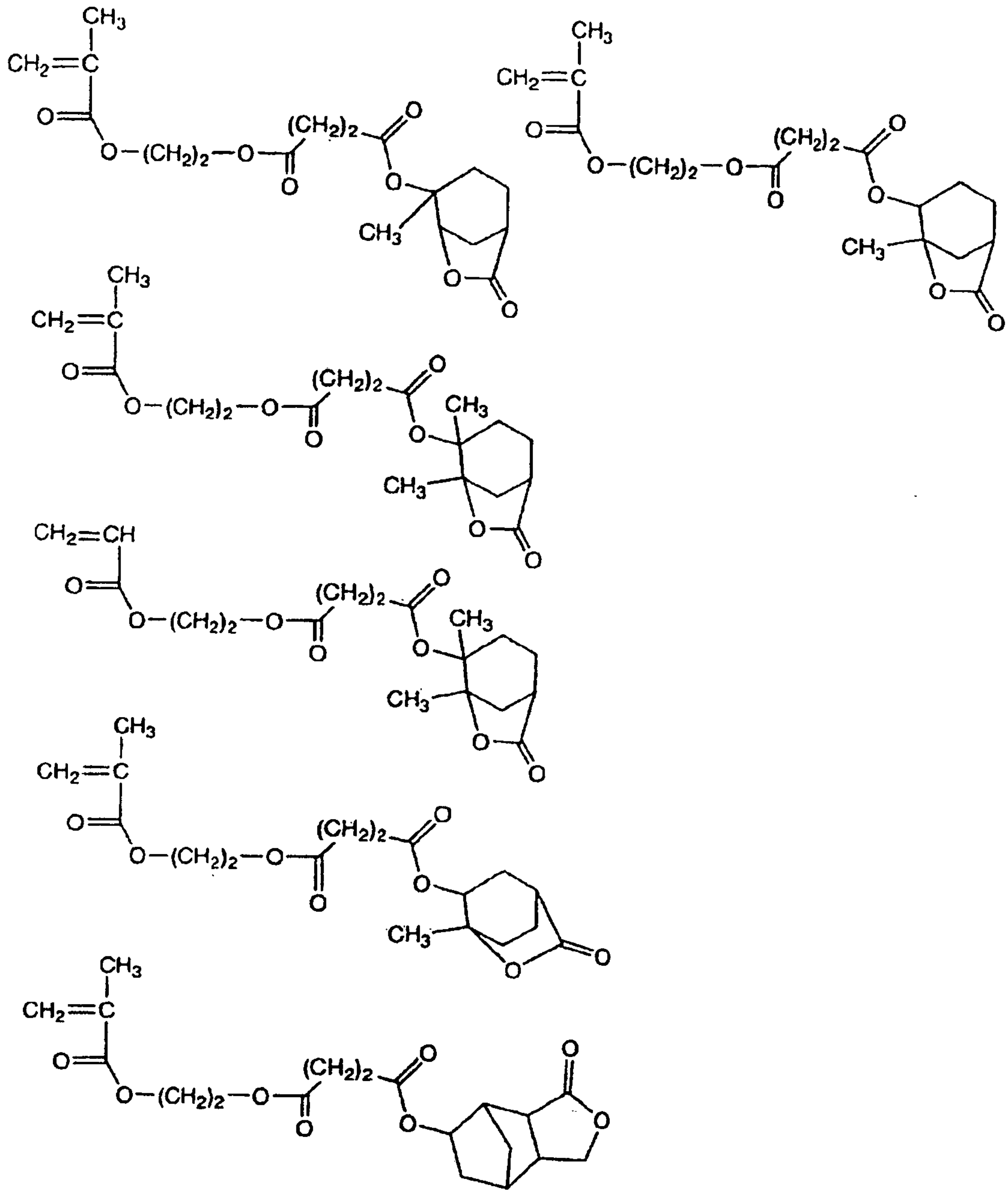

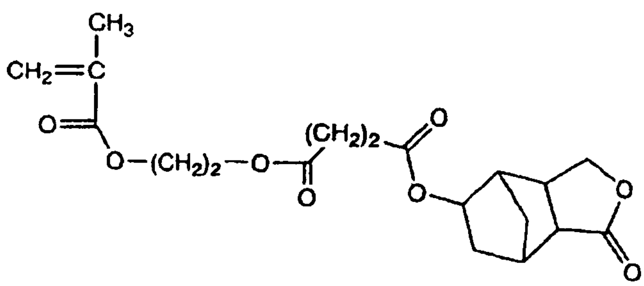

The polymer chain constituting the arm part of the star polymer of the present invention contains a repeating unit having an acid degrading/leaving group, and it is preferred that the repeating unit is a repeating unit of (meth)acrylic acid ester derivative represented by formula (I) wherein $R_2$ is an acid degrading/leaving group, or an organic group containing an acid degrading/leaving group. An acid degrading/leaving group means a group that decomposes or detaches by the action of the acid, and specific examples include an alicyclic hydrocarbon group such as adamantyl group and cyclohexyl group, or a substituent shown in the following formulae (wherein k represents 0 or 1).

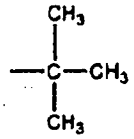 $-(CH_2)_kCO_2Bu\text{-}t$ 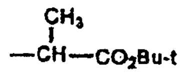 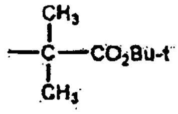

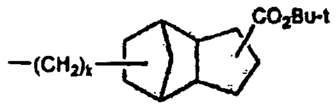 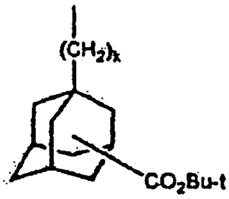 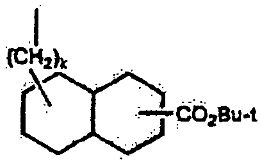

The arm part of the star polymer preferably contains a repeating unit of (meth)acrylic acid ester derivative represented by formula (I) wherein $R_2$ is an alkyl group having a tertiary carbon at the $\alpha$ site of ester oxygen, in view of solubility to the solvent and stability. Specifically, a repeating unit induced from t-butylacrylate, t-butylmethacrylate, 1,1-dimethylpropyl acrylate, 1,1-dimethylmethacrylate, etc. can be exemplified. It is preferred that the repeating unit is contained by 5 to 30 mol%, more preferably 5 to 25 mol%, and most preferably 5 to 20 mol% with respect to all repeating units of the polymer chain in the arm part.

The arm part of the star polymer can contain compounds shown in the following according to need, other than (meth)acrylic acid ester derivative represented by formula (I).

Examples include: crotonic acid esters such as methyl crotonate, ethyl crotonate, propyl crotonate, amyl crotonate, cyclohexyl crotonate, ethylhexyl crotonate, octyl crotonate, crotonic acid-t-octyl, chloroethyl crotonate, 2-ethoxyethyl crotonate, 2,2-dimethyl-3-ethoxypropyl crotonate, 5-ethoxypentyl crotonate, 1-methoxyethyl crotonate, 1-ethoxyethyl crotonate, 1-methoxypropyl crotonate, 1-methyl-1-methoxyethyl crotonate, 1-(isopropoxy)ethylcrotonate, benzyl crotonate, methoxybenzyl crotonate, furfuryl crotonate, tetrahydrofurfurylcrotonate; and itaconic acid esters such as dimethyl itaconate, diethyl itaconate, dipropyl itaconate, diamyl itaconate, dicyclohexyl itaconate, itaconic acid bis (ethylhexyl), dioctyl itaconate, itaconic acid-di-t-octyl, bis (chloroethyl) itaconate, bis(2-ethoxyethyl)itaconate, bis(2,2-dimethyl-3-ethoxypropyl)itaconate, bis(5-ethoxypentyl)itaconate, bis(1-methoxyethyl)itaconate, bis(1-ethoxyethyl)itaconate, bis(1-methoxypropyl)itaconate, bis(1-methyl-1-methoxyethyl)itaconate, bis(1-(isopropoxy)ethyl)itaconate, dibenzyl itaconate, bis(methoxybenzyl)itaconate, difurfuryl itaconate, and ditetrahydrofurfuryl itaconate.

The present invention will be further explained in the following by referring to the Examples, while the present invention is not limited to the Examples.

[Example 1]

Under a nitrogen atmosphere, 302 g of tetrahydrofuran (hereinafter abbreviated to as THF) containing 25 mmol of lithium chloride was kept at -50°C, and was added with 13 mmol of sec-butyl lithium (hereinafter abbreviated to as SBL) by stirring. 14 g of THF solution containing 25 mmol of 2,5-dimethyl-2,5-hexanediol dimethacrylate (hereinafter abbreviated to as MDMA) was dropped, and the reaction was continued for 30 min. A small amount of reaction solution was collected from the reaction system, and it was confirmed by gas chromatography (hereinafter abbreviated to as GC) that MDMA monomer had been completely consumed.

Next, 64 g of THF solution containing 225 mmol of tert-butyl methacrylate (hereinafter abbreviated to as tBMA) was dropped, and the reaction was continued for 30 min. A small amount of reaction solution was collected from the reaction system, and it was confirmed by GC that tBMA monomer had been completely consumed.

Then, 5 g of methanol was added to stop the reaction. Ethyl acetate was added to the reaction terminating solution, and the resultant was washed with water until it is neutralized by a separating operation. The solvent of the organic layer was distilled away, and a white powder was obtained. Yield: 35 g.

The polymer was analyzed by GPC, and it was a polymer with Mn = 16500, Mw = 29700, and having a dispersity Mw/Mn = 1.80 (RI detection).

The theoretical molecular weight calculated from the added initiator and the monomer, specifically the molecular weight supposing that all of the monomers become a linear polymer without cross-linking reaction is 4000, and the peak corresponding to this molecular weight was not detected.

From the GPC measurement with a multi angle laser light scattering (MALLS detection), the results were: Mn = 71200, Mw = 109100, and dispersity Mw/Mn = 1.53.

The measured molecular weight was larger for the absolute molecular weight by MALLS detection, compared to the relative molecular weight by RI detection. This shows that the inertial radical of the generated polymer is smaller

compared to the linear polymer having the same molecular weight, and it was shown that the generated polymer is a star polymer.

[Comparative Example 1] (when the used amount of SBL is large)

Synthesis was performed similarly as Example 1, except that the added amount of the initiator SBL was 25 mmol.
The obtained polymer was analyzed by GPC, and it was a two-peak chromatogram which peak top molecular weights (hereinafter abbreviated to as MP) were 10200 and 3500.
The theoretical molecular weight calculated from the added initiator and the monomer, specifically the molecular weight supposing that all of the monomers become a linear polymer without cross-linking reaction is 2000, and the component of MP = 10200 was a star polymer, and the component of MP = 3500 was a nonbranched linear polymer (growth at both ends) . The area ratio of the star polymer part/linear polymer part = 17/83, and the generation of star polymer was insufficient.

[Examples 2 - 4; Comparative Example 2]

A star polymer was synthesized in the same manner as Example 1 except that the amount of lithium chloride to be used has been changed as shown in Table 1.

[Table 1]

| | Added amount of LiCl (mmol) | Molar ratio of LiCl to SBL | Mn | MW | Mw/Mn |
|---|---|---|---|---|---|
| Example 2 | 13 | 0.75 | 32500 | 35000 | 1.93 |
| Example 3 | 25 | 1.5 | 16500 | 29700 | 1.80 |
| Example 4 | 50 | 3.0 | 17200 | 31700 | 1.85 |
| Comparative Example 2 | Not added | 0 | Gelatinize - deposit | | |

When LiCl was not added, immediately after adding MDMA, it rapidly thickened, gelatinized, and exhibited white turbidity. Some deposits were observed, and living polymerization for arm extension was not achieved.

[Example 5]

Under a nitrogen atmosphere, 321 g of THF containing 27 mmol of lithium chloride (1.5-fold mol with respect to SBL) was kept at -50°C, and was added with 18 mmol of SBL by stirring. 15 g of THF solution containing 27 mmol of MDMA was dropped, and the reaction was continued for 30 min. (ratio of MDMA to SBL: 1:0.67; molar ratio). A small amount of reaction solution was collected from the reaction system, and it was confirmed by GC that MDMA monomer had been completely consumed.
Next, 180 g of THF containing 107 mmol 1-ethyl cyclohexyl methacrylate (hereinafter abbreviated to as ECHMA) and 95 mmol of methacrylic acid-5-oxo-4-oxatricyclo[4.2.1.$0^{3.7}$]nonan-2-yl (hereinafter abbreviated to as NLMA) was dropped, and the reaction was continued for 30 min. A small amount of reaction solution was collected from the reaction system, and it was confirmed by GC that ECHMA monomer and NLMA monomer have been completely consumed. Then, the reaction was stopped by adding a THF solution containing hydrochloric acid.
260 g of ethyl acetate was added to the reaction terminating solution, and the resultant was washed with water until it is neutralized by a separating operation. The solvent of the organic layer was distilled away, and a white solid was obtained. 600 g of propylene glycol monomethyl ether acetate (hereinafter abbreviated to as PGMEA) was added thereto to dissolve it, and concentrated to 150 g. The resultant was diluted by adding 600 g of PGEMA, and concentrated to 230 g. The concentration of the resin part measured by GC was 20.3%.
The obtained resin was analyzed by GPC, and the results were Mn = 14200, Mw= 28100, Mw/Mn = 1.98. The theoretical molecular weight calculated from the added initiator and the monomer, specifically the molecular weight supposing that all of the monomers become a linear polymer without cross-linking reaction is 5100, and the peak corresponding to this molecular weight was not detected.
The composition ratio of this polymer was MDMA : ECHMA : NLMA = 13 : 44 : 43 (molar ratio) from $^{13}$C-NMR measurement.

[Comparative Example 3] (arm-first method)

Under a nitrogen atmosphere, 274 g of THF containing 7 mmol of lithium chloride was kept at -40°C, and was added with 15 mmol of SBL by stirring. 14 g of THF solution containing 33 mmol of ECHMA was dropped, and the reaction was continued for 30 min. A small amount of reaction solution was collected from the reaction system, and it was confirmed by high performance liquid chromatography that ECHMA monomer had been completely consumed. The average polymerization level was also confirmed.

Next the reaction solution was kept at -50°C, 160 g of THF containing 66 mmol of ECHMA and 99 mmol of NLMA was dropped, and the reaction was continued for 30 min. A small amount of reaction solution was collected from the reaction system, and it was confirmed by GC that the monomer had been completely consumed.

Next, 14 g of THF solution containing 17 mmol of MDMA was dropped, and the reaction was continued for further 180 minutes. A small amount of reaction solution was collected from the reaction system, and it was confirmed by GC that EDMA monomer had been completely consumed. Then, the reaction was stopped by adding THF solution containing hydrochloric acid.

230 g of ethyl acetate was added to the reaction terminating solution, and the resultant was washed with water until it is neutralized by a separating operation. The solvent of the organic layer was distilled away, and a white solid was obtained. The resultant was diluted by adding 650 g of PGMEA, and concentrated to 150 g. Then, it was further diluted by adding 650 g of PGEMA, and concentrated to 226 g. The concentration of the resin part measured by GC was 21.0%.

The obtained resin was analyzed by GPC, and it was a mixture of a star polymer and unreacted linear polymer. The area ratio by RI detection was 56:44. The analysis levels of the star polymer moiety were Mn = 22700, Mw = 29100, Mw/Mn = 1.28. The analysis levels of the linear polymer moiety were Mn = 2500, Mw = 3100, Mw/Mn = 1.20.

The composition ratio of this polymer was ECHMA : NLMA : MDMA = 48 : 44 : 9 (molar ratio) from $^{13}$C-NMR measurement.

[Test Example] Resist simulation

i) Preparation of resist solution

The PGMEA solution of the star polymer obtained in Example 5 and Comparative Example 3 was adjusted to a concentration of 10 weight % with PGMEA, to which triphenyl sulfonium trifluoromethane sulfonate was added by 2 parts with respect to the polymer, and triethanolamine was added by 0.2 parts with respect to the polymer.

ii) Formation of resist film

The above sample solution was spin coated on a silicone wafer to which an anti-reflection film (film thickness 78 nm) had been previously formed, and heated at 105°C for 90 seconds. The film thickness of the resist film was 300 nm.

iii) Exposure, development

The resist film was exposed using ArF exima laser as light source with an exposure device (VUVES4500mini, Litho Tech Japan, Corporation). After the exposure, it was heated at 105°C for 90 seconds as a post exposure bake.

The film was developed with a resist development analyzer (RDA-806, Litho Tech Japan, Corporation). 2.38 weight% of aqueous solution of tetramethylammonium hydroxide was used as developer, and the development temperature was 23°C.

iv) Resist simulation

Regist simulation was performed with an analysis software (Prolith) based on the measured data of the above development analyzer, the limiting resolution level was smaller for the polymer produced by a core-first method compared to that produced by an arm-first method. Simulation conditions:
Mask: 6% half tone, pattern: line and space, 100 nm/100 nm illumination: four-pole illumination NA:0.85

[Table 2]

| | Production method | Limiting resolution |
|---|---|---|
| Example 5 | Core-first method | 50 nm |

(continued)

| | Production method | Limiting resolution |
|---|---|---|
| Comparative Example 3 | Arm-first method | 60 nm |

**Industrial Applicability**

The star polymer produced by the method of the present invention is a star polymer with no linear polymer remained, and having transparency.

When compared with a polymer produced by the arm-first method using the same monomer, by a simulation by resist analyzer, the resist using the star polymer obtained by the arm-first method has a limiting resolution of 60 nm, while the resist using the star polymer obtained by the core-first method of the present invention was excellent, being 50 nm.

Further, according to the present invention, as almost no unreacted vinyl groups remain when forming the core part, decrease of transparency or generation of radical which occurs when divinyl benzene is used as a monomer of the core part is not observed.

## Claims

1. A method for producing a star polymer, comprising forming a core part by producing a polymer by polymerizing one or more polyfunctional (meth)acrylic acid ester derivative represented by formula (IV)

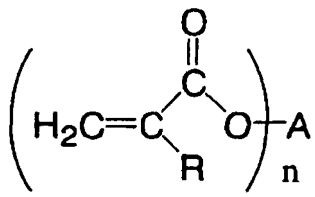

(IV)

(wherein R represents a hydrogen atom or C1-C6 alkyl group, n represents 2 or 3, and A represents an organic group linking at a carbon atom) by anionic polymerization in an organic solvent, in the presence of 0.1 to 0.99 mol of organic alkali metal compound with respect to 1 mol of the compound of the formula (IV), and in the presence of 0.1 to 20 mol of inorganic salt of alkali metal or alkali earth metal with respect to 1 mol of the organic alkali metal compound,
and then, forming an arm part by polymerizing one or more monofunctional (meth)acrylic acid ester derivative represented by formula (I)

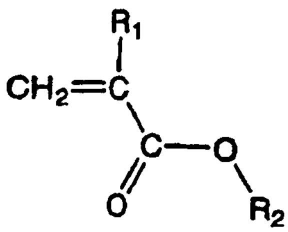

• • • (I)

(wherein $R_1$ represents a hydrogen atom or C1-C5 alkyl group, and $R_2$ represents an organic group) by anionic polymerization from the anionic active site of the core part.

2. The method for producing a star polymer according to claim 1, wherein the halide of alkali metal is lithium chloride, and the organic alkali metal compound is sec-butyl lithium.

3. The method for producing a star polymer according to claim 1 or 2, wherein the polyfunctional (meth)acrylic acid ester derivative represented by formula (IV) is a polyfunctional (meth)acrylic acid ester derivative having at least 2 partial structure represented by formula (II)

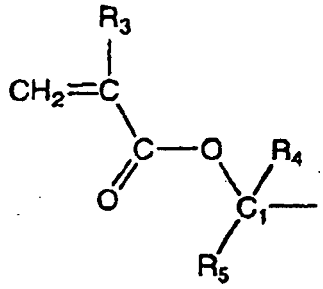

• • • (II)

(wherein $R_3$ represents a hydrogen atom or C1-C6 alkyl group; $R_4$ and $R_5$ each independently represent a hydrogen atom, or an organic group linking at a carbon atom).

**4.** The method for producing a star polymer according to claim 3, wherein the polyfunctional (meth)acrylic acid ester derivative represented by formula (IV) is a polyfunctional (meth)acrylic acid ester derivative represented by formula (III)

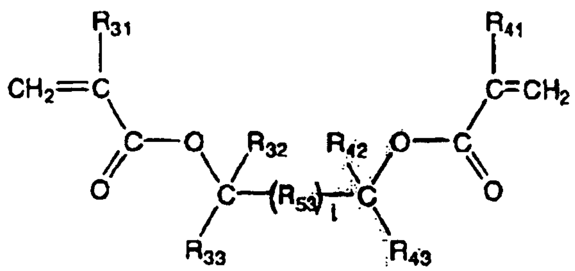

• • • (III)

(wherein, $R_{31}$ and $R_{41}$ each independently represent a hydrogen atom or C1-C6 alkyl group, and $R_{32}$, $R_{33}$, $R_{42}$ and $R_{43}$ each independently represent an organic group linking at a carbon atom, t represents 0 or 1, and $R_{53}$ represents a divalent linking group.

**5.** The method for producing a star polymer according to claim 4, wherein the polyfunctional (meth)acrylic acid ester derivative represented by formula (IV) is 2,5-dimethyl-2,5-hexanediol di(meth)acrylate.

**6.** A star polymer produced by the method according to any one of claims 1 to 5.

## Patentansprüche

**1.** Verfahren zum Herstellen eines Sternpolymers, umfassend das Bilden eines Kernteils durch Herstellen eines Polymers durch Polymerisieren eines oder mehrerer polyfunktionaler (Meth)acrylsäureesterderivate, dargestellt durch die Formel (IV)

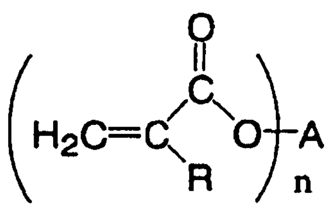

(IV)

(wobei R ein Wasserstoffatom oder eine C1-C6-Alkylgruppe darstellt, n 2 oder 3 darstellt und A eine mit einem Kohlenstoffatom verknüpfte organische Gruppe darstellt) durch anionische Polymerisierung in einem organischen Lösungsmittel in der Gegenwart von 0,1 bis 0,99 mol organischer Alkalimetallverbindung in Bezug auf 1 mol der Verbindung der Formel (IV) und in der Gegenwart von 0,1 bis 20 mol von anorganischem Salz von Alkalimetall oder Erdalkalimetall in Bezug auf 1 mol der organischen Alkalimetallverbindung,

und dann Bilden eines Armteils durch Polymerisieren eines oder mehrerer monofunktionaler (Meth)acrylsäureesterderivate, dargestellt durch die Formel (I)

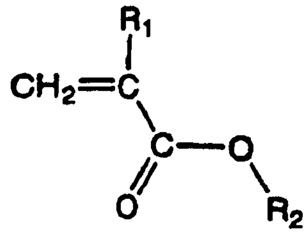

• • • (I)

(wobei $R_1$ ein Wasserstoffatom oder eine C1-C5-Alkylgruppe darstellt und $R_2$ eine organische Gruppe darstellt) durch anionische Polymerisation aus dem anionischen aktiven Zentrum des Kernteils.

**2.** Verfahren zum Herstellen eines Sternpolymers nach Anspruch 1, wobei das Halogenid des Alkalimetalls Lithiumchlorid ist, und die organische Alkalimetallverbindung sec-Butyllithium ist.

**3.** Verfahren zum Herstellen eines Sternpolymers nach Anspruch 1 oder 2, wobei das durch Formel (IV) dargestellte polyfunktionale (Meth)acrylsäureesterderivat ein polyfunktionales (Meth)acrylsäureesterderivat ist mit mindestens 2 Teilstrukturen, dargestellt durch die Formel (II)

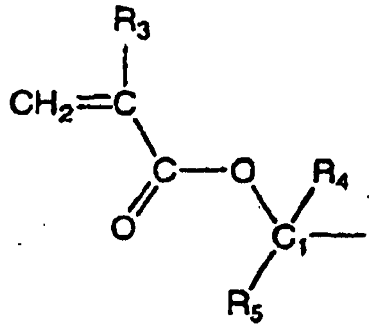

• • • (II)

(wobei $R_3$ ein Wasserstoffatom oder eine C1-C6-Alkylgruppe darstellt; $R_4$ und $R_5$ jeweils unabhängig ein Wasserstoffatom oder eine mit einem Kohlenstoffatom verknüpfte organische Gruppe ist).

**4.** Verfahren zum Herstellen eines Sternpolymers nach Anspruch 3, wobei das durch Formel (IV) dargestellte polyfunktionale (Meth)acrylsäureesterderivat ein durch Formel (III) dargestelltes polyfunktionales (Meth)acrylsäureesterderivat ist

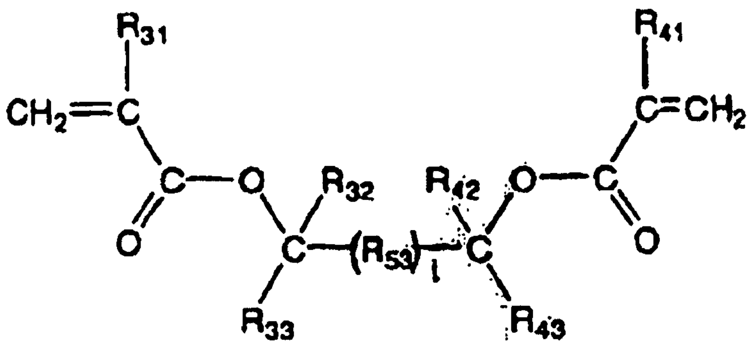

• • • (III)

wobei $R_{31}$ und $R_{41}$ jeweils unabhängig ein Wasserstoffatom oder eine C1-C6-Alkylgruppe darstellt, und $R_{32}$, $R_{33}$, $R_{42}$ und $R_{43}$ jeweils unabhängig eine mit einem Kohlenstoffatom verknüpfte organische Gruppe darstellen, t 0 oder 1 darstellt, und $R_{53}$ eine divalente Verknüpfungsgruppe darstellt.

**5.** Verfahren zum Herstellen eines Sternpolymers nach Anspruch 4, wobei das durch Formel (IV) dargestellte polyfunktionale (Meth)acrylsäureesterderivat 2,5-Dimethyl-2,5-hexandioldi(meth)acrylat ist.

**6.** Sternpolymer, hergestellt durch das Verfahren gemäß einem beliebigen der Ansprüche 1 bis 5.

## Revendications

**1.** Procédé de production d'un polymère en étoile, comprenant la formation d'une partie de noyau en produisant un polymère par polymérisation d'un ou plusieurs dérivés polyfonctionnels d'ester d'acide (méth)acrylique représentés par la formule (IV)

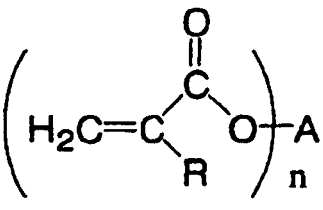

(IV)

(dans laquelle R représente un atome d'hydrogène ou un groupe alkyle en $C_1$-$C_6$, n représente 2 ou 3, et A représente un groupe organique se liant au niveau d'un atome de carbone) par polymérisation anionique dans un solvant organique, en présence de 0,1 à 0,99 mole d'un composé organique de métal alcalin pour 1 mole du composé de la formule (IV), et en présence de 0,1 à 20 moles d'un sel inorganique de métal alcalin ou de métal alcalinoterreux pour 1 mole du composé organique de métal alcalin,
et ensuite, formation d'une partie de bras par polymérisation d'un ou plusieurs dérivés monofonctionnels d'ester d'acide (méth)acrylique représentés par la formule (I)

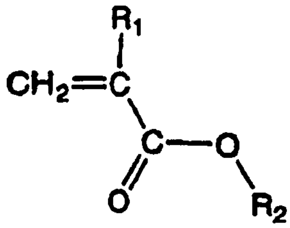

• • • (I)

(dans laquelle $R_1$ représente un atome d'hydrogène ou un groupe alkyle en $C_1$-$C_5$, et $R_2$ représente un groupe organique) par polymérisation anionique à partir du site anionique actif de la partie de noyau.

**2.** Procédé de production d'un polymère en étoile selon la revendication 1, dans lequel l'halogénure de métal alcalin est un chlorure de lithium, et le composé organique de métal alcalin est un sec-butyllithium.

**3.** Procédé de production d'un polymère en étoile selon la revendication 1 ou 2, dans lequel le dérivé polyfonctionnel d'ester d'acide (méth)acrylique représenté par la formule (IV) est un dérivé polyfonctionnel d'ester d'acide (méth)acrylique ayant au moins deux structures partielles représentées par la formule (II)

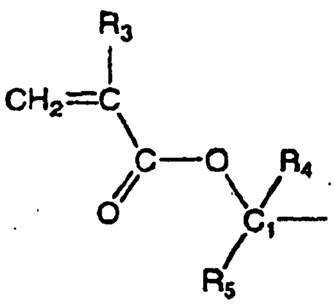

• • • (II)

(dans laquelle $R_3$ représente un atome d'hydrogène ou un groupe alkyle en $C_1$-$C_6$ ; $R_4$ et $R_5$ représentent chacun indépendamment un atome d'hydrogène ou un groupe organique se liant au niveau d'un atome de carbone).

**4.** Procédé de production d'un polymère en étoile selon la revendication 3, dans lequel le dérivé polyfonctionnel d'ester d'acide (méth)acrylique représenté par la formule (IV) est un dérivé polyfonctionnel d'ester d'acide (méth)acrylique représenté par la formule (III)

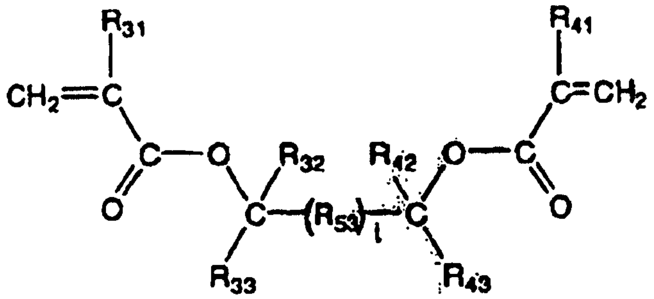

• • • (III)

(dans laquelle $R_{31}$ et $R_{41}$ représentent chacun indépendamment un atome d'hydrogène ou un groupe alkyle en $C_1$-$C_6$, et $R_{32}$, $R_{33}$, $R_{42}$ et $R_{43}$ représentent chacun indépendamment un groupe organique se liant au niveau d'un atome de carbone, t représente 0 ou 1, et $R_{53}$ représente un groupe de liaison divalent.

**5.** Procédé de production d'un polymère en étoile selon la revendication 4, dans lequel le dérivé polyfonctionnel d'ester d'acide (méth)acrylique représenté par la formule (IV) est un di(méth)acrylate de 2,5-diméthyl-2,5-hexanediol.

**6.** Polymère en étoile produit par le procédé selon l'une quelconque des revendications 1 à 5.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11029617 A
- JP 2006225605 A
- JP 3188611 B
- JP 6219966 A
- WO 9623012 A1
- EP 1752479 A1


### Non-patent literature cited in the description


- *Macromolecules,* 1996, vol. 29, 3390-3396
- *Macromolecules,* 1999, vol. 32, 534-536
- *Macromolecules,* 2001, vol. 34, 7629-7635
- *Macromolecules,* 2005, vol. 38, 2911-2917
- *Macromolecules,* 1999, vol. 32, 6526-6535
- *Macromolecules,* 1991, vol. 24, 5897-5902